# EUROPÄISCHE PATENTSCHRIFT

(11) **EP 1 511 362 B1**
(45) Veröffentlichungstag und Bekanntmachung des Hinweises auf die Patenterteilung: **25.02.2009**
(21) Anmeldenummer: 04019541.4
(22) Anmeldetag: 18.08.2004
(51) Int. Cl.: H05B 33/08

(54) **Fahrzeugleuchte**
Automotive lamp
Feux de véhicule

(30) Priorität: 27.08.2003 DE 10339417
(43) Veröffentlichungstag der Anmeldung: 02.03.2005
(73) Patentinhaber: Hella KGaA Hueck & Co., 59552 Lippstadt (DE)
(72) Erfinder: Ewen, Dietmar, 33106 Paderborn (DE)
(74) Vertreter: Ostermann, Thomas

(56) Entgegenhaltungen:
- EP-A1- 1 134 849
- DE-A1- 4 438 299
- US-A- 5 109 319

## Beschreibung

Die Erfindung bezieht sich auf eine Fahrzeugleuchte mit einer Leiterplatte, auf der mindestens eine Leuchtdiode und Anschlusskontakte für die Versorgungsspannung und das Bezugspotential der Leuchtdiode angeordnet sind, und mit einem mit den Anschlusskontakten der Leiterplatte elektrisch kontaktierbaren Verbindungselement (Stecker), welches zu den Anschlusskontakten korrespondierende Kontaktelemente zur Zuführung der Versorgungsspannung und des Bezugspotentials aufweist.

Falls ein solcher Stecker keine mechanische Steckcodierung aufweist, die verhindert, dass der Stecker fälschlicherweise in einer verkehrten (um 180° verdrehten) Position an der Leiterplatte montiert wird, kann es zur einer falschen Kontaktierung (Polung) der Anschlusskontakte kommen, wobei dann Versorgungsspannung und Bezugspotential vertauscht sind. Dies würde zu einer Zerstörung der auf der Leiterplatte angeordneten Leuchtdiode führen.

Eine aus dem Stand der Technik bekannte Lösung dieses Problems bei Steckverbindungen ohne mechanische Steckcodierung ist das Vorsehen einer Graetz-Schaltung auf der Leiterplatte. Dies erfordert jedoch vier Dioden, wodurch zusätzliche Kosten verursacht werden.

Aufgabe der Erfindung ist es daher, in einfacher und kostengünstiger Weise einen Verpolungsschutz zu schaffen.

Zur Lösung dieser Aufgabe sind auf der Leiterplatte drei nebeneinander angeordnete, eine Kontaktgruppe bildende Anschlusskontakte angeordnet, wobei die beiden äußeren Anschlusskontakte symmetrisch zum mittleren Anschlusskontakt angeordnet, miteinander leitend verbunden und anodenseitig gemeinsam an die Leuchtdiode angeschlossen sind, während der mittlere Anschlusskontakt kathodenseitig an die Leuchtdiode angeschlossen ist. Dementsprechend weist das Verbindungselement (vorzugsweise ein Stecker) mindestens zwei nebeneinander angeordnete Kontaktelemente aufweist, nämlich ein erstes Kontaktelement, das korrespondierend zum mittleren Anschlusskontakt angeordnet ist und ein zweites Kontaktelement, das korrespondierend zu einem äußeren Anschlusskontakt angeordnet ist, wobei das dem äußeren Anschlusskontakt zugeordnete Kontaktelement mit der Versorgungsspannung verbunden ist, während das mittlere Kontaktelement mit dem Bezugspotential verbunden ist. Auf diese Weise wird ohne zusätzliche Bauelemente sichergestellt, dass, unabhängig davon, ob das Verbindungselement in einer ersten oder in einer dazu um 180° verdrehten zweiten Position an der Leiterplatte montiert wird, die Leuchtdiode anodenseitig immer mit Versorgungsspannung und kathodenseitig immer dem Bezugspotential verbunden ist.

Selbstverständlich ist es alternativ dazu genauso gut möglich, dass die beiden äußeren Anschlusskontakte kathodenseitig an die Leuchtdiode angeschlossen sind, während dann der mittlere Anschlusskontakt anodenseitig an die Leuchtdiode angeschlossen ist. Dementsprechend vertauscht ist dann auch die Polarität der Kontaktelemente des Verbindungselements.

Anhand der beigefügten Zeichnungen soll die Erfindung nachfolgend näher erläutert werden. Es zeigt:
- Figur 1: eine Graetz-Schaltung als Verpolungsschutz gemäß dem Stand der Technik,
- Figur 2: eine erste Ausführungsform der Erfindung,
- Figur 3: eine abgewandelte Variante der ersten Ausführungsform,
- Figur 4: eine zweite Ausführungsform der Erfindung.

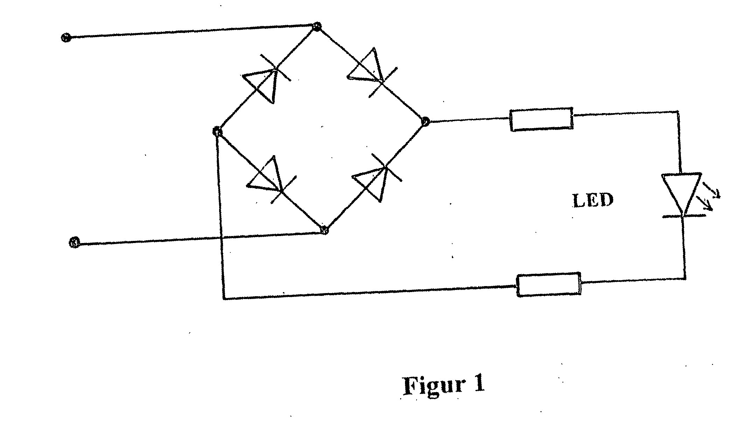

Figur 1 zeigt eine aus dem Stand der Technik bekannte Lösung, bei der als Verpolungsschutz für die Leuchtdiode (LED) eine Graetz-Schaltung vorgesehen ist.

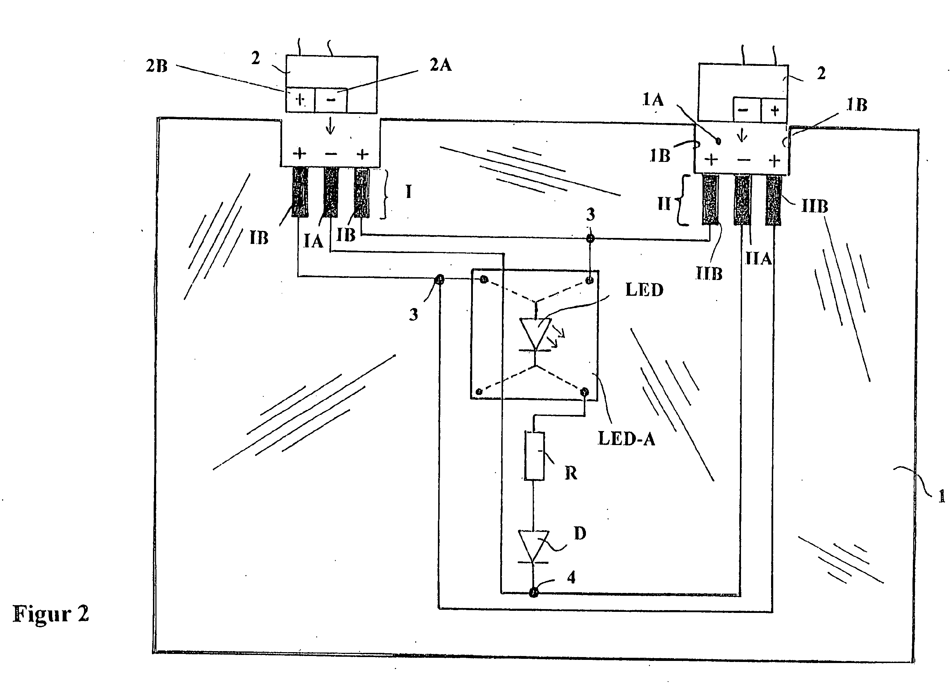

Figur 2 zeigt eine erste Ausführungsform der Erfindung. Auf der Leiterplatte (1), welche in die Fahrzeugleuchte eingebaut wird, befindet sich als Lichtquelle eine Leuchtdiode (LED). Daneben gibt es auf der Leiterplatte (1) eine erste Kontaktgruppe (I) mit drei nebeneinander angeordneten Anschlusskontakten, welche vorzugsweise als breite Leiterbahnen randseitig auf der Leiterplatte (1) ausgebildet sind. Die beiden äußeren Anschlusskontakte (IB) sind symmetrisch zum mittleren Anschlusskontakt (IA) angeordnet. Dabei sind die äußeren Anschlusskontakte (IB) miteinander leitend verbunden und anodenseitig über den Knotenpunkt (3) an die Leuchtdiode (LED) angeschlossen. Der mittlere Anschlusskontakt (IA) der Kontaktgruppe (I) ist über den Knotenpunkt (4) kathodenseitig an die Leuchtdiode (LED ) angeschlossen.

Das Verbindungselement (2) weist mindestens zwei nebeneinander angeordnete Kontaktelemente (2A, 2B) auf, nämlich ein erstes Kontaktelement (2A), das korrespondierend zum mittleren Anschlusskontakt (IA) angeordnet ist und ein zweites Kontaktelement (2B), das korrespondierend zu einem äußeren Anschlusskontakt (IB) angeordnet ist. Dabei sind Führungsmittel vorgesehen, die dafür sorgen, dass das Verbindungselement (2) in der ersten und in der um 180° verdrehten Position immer nur so auf der Leiterplatte (1) angeordnet werden kann, dass das erste Kontaktelement (2A) korrespondierend zum mittleren Anschlusskontakt (IA) angeordnet ist. Dann ist das andere Kontaktelement (2B) automatisch mit einem äußeren Anschlusskontakt (dem linken oder dem rechten) verbunden. Das erste Kontaktelement (2a) ist somit in der Mitte des Verbindungselements (2) angeordnet. Zur seitlichen Führung des Verbindungselements (2) weist die Leiterplatte (1) im Bereich der Kontaktgruppe (I) eine Aussparung (1A) als Einsteckführung auf, wobei die durch die Aussparung (1A) gebildeten Seitenränder (1B) der Leiterplatte (1) eine seitliche Führung für die Seitenwände des Verbindungselements (2) bilden.

Das den äußeren Anschlusskontakten (IB) zugeordnete Kontaktelement (2B) ist mit der fahrzeugseitigen Versorgungsspannung (+) verbunden, während das dem mittleren Anschlusskontakt (IA) zugeordnete Kontaktelement (2A) mit dem fahrzeugseitigen Bezugspotential (-) verbunden ist. Zur Zuleitung von Versorgungsspannung und Bezugspotential zum Verbindungselement sind an demselben entsprechende Kabel vorgesehen.

Zur Einstellung des Stroms durch die Leuchtdiode (LED) ist in Reihe mit dieser auf der Leiterplatte (1) noch ein Widerstand (R) angeordnet. Um zu verhindern, dass negative Spannungsspitzen auf der Versorgungsspannungsleitung zu einer Beschädigung der Leuchtdiode führen, ist zusätzlich noch eine Sperrdiode (D) in Reihe geschaltet.

Die Leuchtdiode (LED) befindet sich in einem Gehäuse (LED-A), aus dem vier Anschlusspins herausgeführt sind, und zwar zwei für die anodenseitige Kontaktierung der Leuchtdiode und zwei für die kathodenseitige Kontaktierung. Dabei sind die Leiterbahnen auf der Leiterplatte zur Vermeidung von Überkreuzungen (Verbrückung) um die Anschlusspins herumgeführt.

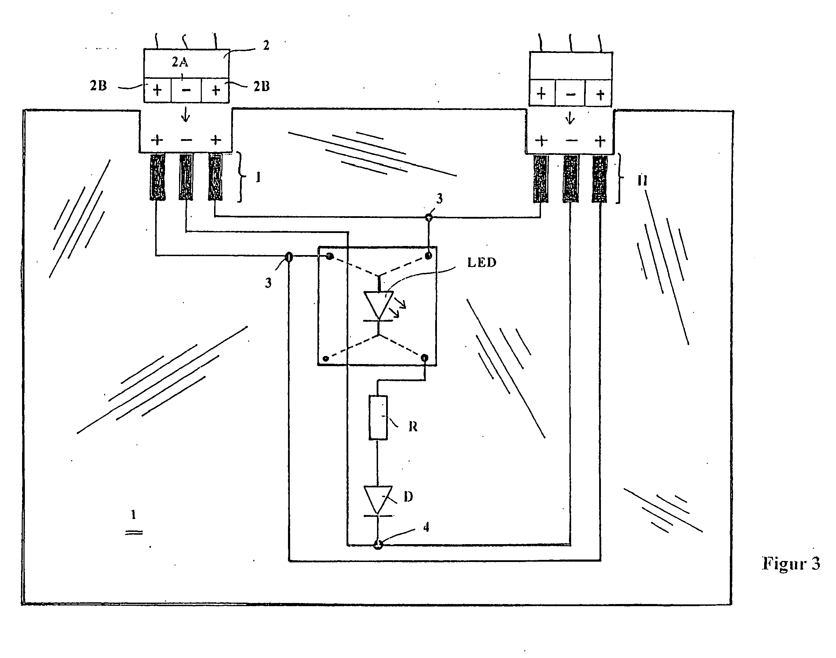

Figur 3 zeigt eine leicht abgewandelte Ausführungsform bei der das Verbindungselement (2) drei nebeneinander angeordnete Kontaktelemente aufweist, nämlich zwei äußere Kontaktelemente (2B) und ein mittleres Kontaktelement (2A), wobei die beiden äußeren Kontaktelemente symmetrisch zum mittleren Kontaktelement angeordnet sind. Auf diese Weise kann auf einen ganz gewöhnlichen handelsüblichen Stecker mit drei nebeneinander angeordneten Kontaktelementen zurückgegriffen werden, wobei allerdings nur der mittlere und einer der äußeren Kontaktelemente mit einem Kabel verbunden sein muß. Das Verbindungselement ist als Stecker (2) mit zwei übereinander angeordneten Reihen von jeweils mindestens zwei Kontaktfederelementen ausgebildet ist, wobei der Stecker mit den Kontaktfederelementen im Bereich der Anschlusskontakte (IA, IB) randseitig klemmend auf die Leiterplatte (1) gesteckt wird.

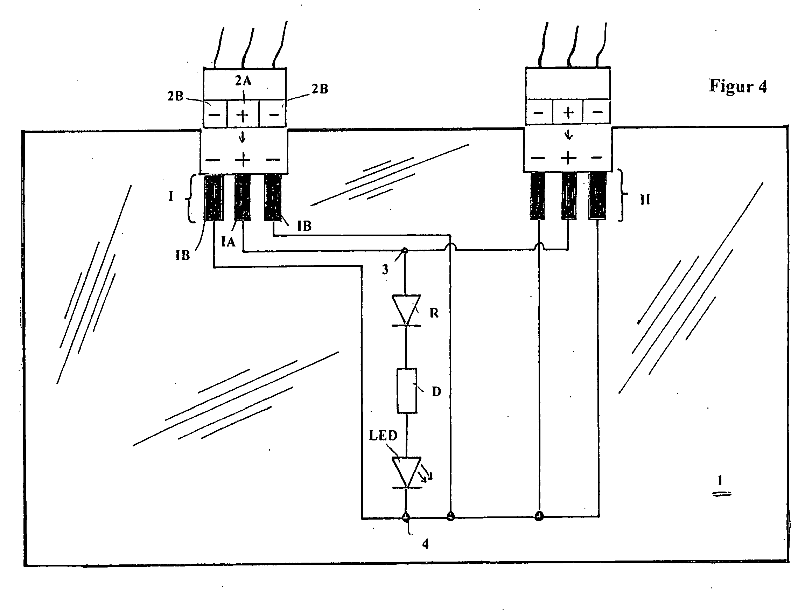

Figur 4 zeigt eine alternative Ausführungsform gemäß Fall b) des Anspruches 1. Bei dieser Ausführungsform sind die beiden äußeren Anschlusskontakte (IB) auf der Leiterplatte (1) kathodenseitig im Knotenpunkt (4) mit der Leuchtdiode (LED) verbunden, während der mittlere Anschlusskontakt (IA) anodenseitig über den Knotenpunkt (3) mit der Leuchtdiode (LED) verbunden ist. Die Polarität der Kontaktelemente des Verbindungselements (2) ist dann dementsprechend geändert.

In einer vorteilhaften Weiterbildung der Erfindung ist auf der Leiterplatte (1) neben der ersten Kontaktgruppe (I) eine zweite Kontaktgruppe (II) bestehend aus drei nebeneinander angeordneten Anschlusskontakten vorgesehen, wobei die beiden äußeren Anschlusskontakte (IB) der ersten Kontaktgruppe mit den beiden äußeren Anschlusskontakte (IIB) der zweiten Kontaktgruppe leitend verbunden sind, und der mittlere Anschlusskontakt (IA) der ersten Kontaktgruppe mit dem mittleren Anschlusskontakt (IIB) der zweiten Kontaktgruppe leitend verbunden ist. Auf diese Weise wird eine universell einsetzbare Leuchtdioden-Leiterplatte geschaffen, die entsprechend dem zur Verfügung stehenden Bauraum in der Fahrzeugleuchte und den entsprechenden Zugangsmöglichkeiten an zwei verschiedenen Stellen kontaktiert werden kann.

Abschließend soll noch erwähnt werden, dass die Erfindung nicht auf eine Leiterplatte mit einer Leuchtdiode beschränkt ist. Die Erfindung ist vielmehr auch auf Leiterplatten mit einer Leuchtdiodenanordnung aus mehreren Leuchtdioden anwendbar.

### Bezugszeichenliste

1) Leiterplatte
   1A) Aussparung in der Leiterplatte
   1B) Führungsränder für Verbindungselement
I) Erste Kontaktgruppe
   IA) Mittlerer Anschlusskontakt
   IB) Äußere Anschlusskontakte
II) Zweite Kontaktgruppe
   IIA) Mittlerer Anschlusskontakt
   IIB) Äußere Anschlusskontakte
LED) Leuchtdiode
   LED-A) Leuchtdioden-Gehäuse
   LED-B) Anschlusspins der Leuchtdiode
R) Widerstand
D) Sperrdiode
2) Verbindungselement
   2A) Erstes Kontaktelement
   2B) Zweites Kontaktelement
3) Anodenseitige(r) Knotenpunkt(e)
4) Kathodenseitige(r) Knotenpunkt(e)

## Patentansprüche

1. Fahrzeugleuchte mit
- einer Leiterplatte (1), auf der mindestens eine Leuchtdiode (LED) und Anschlusskontakte (IA,IB) für die Versorgungsspannung und das Bezugspotential der Leuchtdiode (LED) angeordnet sind,
- einem mit den Anschlusskontakten (IA,IB) der Leiterplatte (1) elektrisch kontaktierbaren Verbindungselement (2) mit zu den Anschlusskontakten (IA,IB) korrespondierenden Kontaktelementen (2A, 2B) zur Zuführung der Versorgungsspannung und des Bezugspotentials,
**dadurch gekennzeichnet, daß**
- auf der Leiterplatte (1) drei nebeneinander angeordnete, eine Kontaktgruppe (I) bildende Anschlusskontakte angeordnet sind, wobei die beiden äußeren Anschlusskontakte (IB) symmetrisch zum mittleren Anschlusskontakt (IA) angeordnet und miteinander leitend verbunden sind, wobei
a) die beiden äußeren Anschlusskontakte (IB) anodenseitig an die Leuchtdiode angeschlossen sind und der mittlere Anschlusskontakt (IA) kathodenseitig an die Leuchtdiode angeschlossen ist, oder
b) die beiden äußeren Anschlusskontakte (IB) kathodenseitig an die Leuchtdiode angeschlossen sind und der mittlere Anschlusskontakt (IA) anodenseitig an die Leuchtdiode angeschlossen ist,
- das Verbindungselement (2) mindestens zwei nebeneinander angeordnete Kontaktelemente (2A, 2B) aufweist, nämlich ein erstes Kontaktelement (2A), das korrespondierend zum mittleren Anschlusskontakt (IA) angeordnet ist und ein zweites Kontaktelement (2B), das korrespondierend zu einem äußeren Anschlusskontakt (IB) angeordnet ist, wobei
im Fall a) das dem äußeren Anschlusskontakt (IB) zugeordnete Kontaktelement (2B) mit der Versorgungsspannung verbunden sind, während das dem mittleren Anschlusskontakt (IA) zugeordnete Kontaktelement (2A) mit dem Bezugspotential verbunden ist,
oder
im Fall b) das dem äußeren Anschlusskontakt (IB) zugeordnete Kontaktelement (2B) mit dem Bezugspotential verbunden sind, während das dem mittleren Anschlusskontakt (IA) zugeordnete Kontaktelement (2A) mit der Versorgungsspannung verbunden ist.

2. Fahrzeugleuchte nach Anspruch 1,
**dadurch gekennzeichnet, dass**
die Anschlusskontakte (IA, IB) randseitig auf der Leiterplatte (1) angeordnet sind.

3. Fahrzeugleuchte nach Anspruch 2,
**dadurch gekennzeichnet, dass**
das Verbindungselement (2) als Stecker mit zwei übereinander angeordneten Reihen von jeweils mindestens zwei Kontaktfederelementen ausgebildet ist, wobei der Stecker mit den Kontaktfederelementen im Bereich der Anschlusskontakte (IA, IB) randseitig klemmend auf die Leiterplatte (1) gesteckt wird.

4. Fahrzeugleuchte nach Anspruch 1,
**dadurch gekennzeichnet, daß**
das Verbindungselement (2) drei nebeneinander angeordnete Kontaktelemente aufweist, nämlich ein erstes Kontaktelement (2A), das korrespondierend zum mittleren Anschlusskontakt (IA) angeordnet ist und zwei äußere Kontaktelemente (2B), die korrespondierend zu den äußeren Anschlusskontakten (IB) angeordnet sind, wobei
im Fall a) wenigstens eines der äußeren Kontaktelemente (2B) mit der Versorgungsspannung verbunden ist, während das dem mittleren Anschlusskontakt (IA) zugeordnete Kontaktelement (2A) mit dem Bezugspotential verbunden ist, oder
im Fall b) wenigstens eines der äußeren Kontaktelemente (2B) mit dem Bezugspotential verbunden sind, während das dem mittleren Anschlusskontakt (IA) zugeordnete Kontaktelement (2A) mit der Versorgungsspannung verbunden ist.

5. Fahrzeugleuchte nach einem der vorstehenden Ansprüche,
**dadurch gekennzeichnet, daß**
auf der Leiterplatte (1) eine zweite Kontaktgruppe (II) bestehend aus drei nebeneinander angeordneten Anschlusskontakten vorgesehen ist, wobei
- die beiden äußeren Anschlusskontakte (IB) der ersten Kontaktgruppe mit den beiden äußeren Anschlusskontakte (IIB) der zweiten Kontaktgruppe leitend verbunden sind,
- der mittlere Anschlusskontakt (IA) der ersten Kontaktgruppe mit dem mittleren Anschlusskontakt (IIA) der zweiten Kontaktgruppe leitend verbunden ist.

## Claims

1. Automotive lamp comprising a circuit board (1) on which at least one light emission diode (LED) and a number of connecting contacts (IA, IB) for the supply voltage and for the reference potential of the light remission diode (LED) are disposed and a connecting element (2) adapted to be electrically contacted with said connecting contacts (IA, IB) of the circuit board (1) which connecting element is provided with contact elements (2A, 2B) arranged to correspond to said connecting contacts (IA, IB) for feeding the supply voltage and the reference potential, **characterized by** the fact that three connecting contacts constituting a contact group (I) are arranged side by side on said circuit board (I) of which the two outer connecting contacts (IB) are symmetrical to the central connecting contact (IA) and conductively connected with each other wherein a) the two outer connecting contacts are connected to the light emission diode on their anode side and the central connecting contact (IA) is connected thereto on its cathode side or b) the two outer connecting contacts are connected to the light emission diode on their cathode side and the central connecting contact (IA) is connected thereto on its anode side, wherein the connecting element (2) has at least two contact elements (2A, 2B) arranged side by side, namely a first contact element (2A) arranged to correspond to the central connecting contact (IA) and a second contact element (2B) arranged to correspond to one of the outer contacts (IB) and wherein in case a) the contact element (2B) allocated to said outer connecting contact (IB) is connected to carry the supply voltage while the contact element (2A) allocated to the central connecting contact (IA) is connected to carry the reference potential or in case b) the contact element (2B) allocated to said outer connecting contact (IB) is connected to carry the reference potential while the contact element (2A) allocated to the central connecting contact (IA) is connected to carry the supply voltage.

2. Automotive lamp according to Claim 1, **characterized by** the fact that the connecting contacts (IA, IB) are disposed in a marginal area of the circuit board (1).

3. Automotive lamp according to Claim 2, **characterized by** the fact that the connecting element (2) is provided as a plug having two superimposed rows each comprising at least two contact spring elements and that the plug is by said contact spring elements plugged/clamped to the circuit board (1) in the area of said connecting contacts (IA, IB).

4. Automotive lamp according to Claim 1, **characterized by** the fact that the connecting element (2) has three contact elements arranged side by side, namely a first contact element (2A) arranged to correspond to the central connecting contact (IA) and two outer contact elements (2B) arranged to correspond to the outer connecting contacts (IB) wherein in case a) at least one of the outer contact elements (2B) is connected to carry the supply voltage while the contact element (2A) allocated to the central connecting contact (IA) is connected to carry the reference potential or in case b) at least one of the outer contact elements (2B) is connected to carry the reference potential while the contact element (2A) allocated to the central connecting contact (IA) is connected to carry the supply voltage.

5. Automotive lamp according to any of the preceding Claims, **characterized by** the fact that a second contact group (II) comprising three connecting contacts arranged side by side is provided on the circuit board (1) wherein the two outer connecting contacts (IB) of the first contact group are conductively connected to the two outer connecting contacts (IIB) of the second contact group and the central connecting contact (IA) of the first contact group is in conductive communication with the central connecting contact (IIA) of the second contact group.

## Revendications

1. Feu de véhicule automobile avec
- une plaquette de circuits imprimés (1), sur laquelle sont disposées au moins une diode luminescents (LED) et des contacts de raccordement (IA, IB) pour la tension d'alimentation et le potentiel de référence de la diode électroluminescente (LED)
- un élément de connexion (2) pouvant entrer en contact électrique avec les contacts de raccordement (1A, 1B) de la plaquette de circuits imprimés (1), avec des éléments de contact (2A, 2B) correspondants aux contacts de raccordement (1A, 1B) pour l'approvisionnement en tension d'alimentation et en potentiel de référence,
**caractérisé en ce que**,
- sur la plaquette de circuits imprimés (1), sont installés des contacts de raccordement disposés les uns à côté de l'autre, qui forment un groupe de contacts (I), les deux contacts de raccordement extérieurs (IB) étant disposés symétriquement par rapport au contact de raccordement central (IA), et en connexion conductrice entre eux,
a) les deux contacts de raccordement extérieurs (IB) étant raccordées à la diode électroluminescente, côté anode, et le contact de raccordement central (IA) étant raccordé à la diode électroluminescente, côté cathode,
ou
b) les deux contacts de raccordement extérieurs (IB) étant raccordées la diode électroluminescente, côté cathode, et le contact de raccordement central (IA) étant raccordé à la diode électroluminescente, côté anode,
- l'élément de connexion (2) présentant au moins deux éléments de contact (2A, 28) disposés l'un à côté de l'autre, en l'occurrence un premier élément de contact (2A), qui est disposé en correspondait à un contact de raccordement central (IA), et un deuxième élément de contact (2B), qui est disposé en correspondant à un contact de raccordement extérieur (IB), dans le cas a), l'élément de contact (2B), associé au contact de raccordement extérieur (IB), étant relié à la tenson d'alimentation, tandis que l'élément de contact (2A), associé au contact de raccordement central (IA), est relié au potentiel de référence,
ou
dans le cas b), l'élément de contact (2B), associé au contact de raccordement extérieur (IB), étant relié au potentiel de référence, tandis que l'élément de contact (2A), associé au contact de raccordement central (IA), est relié à la tension d'alimentation.

2. Feu de véhicule automobile selon la revendication 1,
**caractérisé en ce que**
les contacts de raccordement (IA, IB) sont disposés sur le bord de la plaquette de circuits imprimés (1)

3. Feu de véhicule automobile selon la revendication 2,
**caractérisé en ce que**
l'élément de connexion (2) est conçu en tant que connecteur à fiches avec deux rangées superposées comprenant chacune au moins deux éléments de contact à ressorts, le connecteur à fiches pouvant être enfiché, coincé sur le bord, avec les éléments de contact à ressorts, dans la zone des contacts de raccordement (IA, IB).

4. Feu de véhicule automobile selon la revendication 1,
**caractérisé en ce que**
l'élément de connexion (2) présente trois éléments de contact, disposés les uns à côté de l'autre, en l'occurrence un premier élément de contact (2A), qui est disposé en correspondant au contact de raccordement central (IA), et deux éléments de contact extérieurs (2B), qui sont disposés en correspondant avec les contacts de raccordement extérieurs (IB),
dans le cas a), au moins l'un des éléments de contact (2B), étant relié à la tenson d'alimentation, tandis que l'élément de contact (2A), associé au contact de raccordement central (IA), est relié au potentiel de référence,
ou
dans le cas b), au moins l'un des éléments de contact extérieur (2B) étant relié au potentiel de référence, tandis que l'élément de contact (2A), associé au contact de raccordement central (IA), est relié à la tension d'alimentation,

5. Feu de véhicule automobile selon l'une des revendications précédentes,
**caractérisée en ce que**,
sur la plaquette de circuits imprimés (1), est prévu un deuxième groupe de contacts (II), qui consiste en trois contacts de raccordement, disposés les uns à côté de l'autre,
- les deux contacts de accordement extérieurs (IB) du premier groupe de contacts étant en connexion conductrice avec les deux contacts de raccordement extérieurs (IIB) du deuxième groupe de contacts,
- le contact de raccordement central (IA) du premier groupe de contacts étant en connexion conductrice avec le contact de raccordement central (IIA) du deuxième groupe de contacts.
